# EUROPÄISCHE PATENTSCHRIFT

(11) **EP 0 692 037 B1**
(45) Veröffentlichungstag und Bekanntmachung des Hinweises auf die Patenterteilung: **18.11.1998**
(21) Anmeldenummer: 94911055.5
(22) Anmeldetag: 21.03.1994
(51) Int. Cl.: C30B 23/00, C30B 29/36

(54) **VORRICHTUNG UND VERFAHREN ZUM HERSTELLEN VON SiC-EINKRISTALLEN**
DEVICE AND PROCESS FOR PRODUCING SiC SINGLE CRYSTALS
PROCEDE ET DISPOSITIF PERMETTANT DE REALISER DES MONOCRISTAUX DE SIC

(30) Priorität: 01.04.1993 DE 4310744
(43) Veröffentlichungstag der Anmeldung: 17.01.1996
(73) Patentinhaber: SIEMENS AKTIENGESELLSCHAFT, 80333 München (DE)
(72) Erfinder: VÖLKL, Johannes, D-91056 Erlangen (DE); LANIG, Peter, D-91058 Erlangen (DE)
(86) Internationale Anmeldenummer: DE9400311
(87) Internationale Veröffentlichungsnummer: WO9423096

(56) Entgegenhaltungen:
- EP-A- 0 554 047
- WO-A-89/04055
- CH-A- 346 864
- DE-A- 3 230 727
- PATENT ABSTRACTS OF JAPAN vol. 14, no. 211 (C-715)(4154) 2. Mai 1990 & JP,A,02 048 495 (SANYO ELECTRIC) 19. Februar 1990
- PATENT ABSTRACTS OF JAPAN vol. 13, no. 328 (C-621)(3676) 24. Juli 1989 & JP,A,01 108 200 (SANYO ELECTRIC) 25. April 1989

## Beschreibung

Die Erfindung betrifft eine Vorrichtung und ein Verfahren zum Herstellen von Einkristallen aus Siliciumcarbid (SiC), die beispielsweise aus der US 4 866 005 bekannt sind.

Ein bekanntes Verfahren zum Herstellen von 510-Einkristallen ist das Sublimieren von technischem SiC in Pulverform und Aufwachsen dieses SiC aus der Gasphase auf einem einkristallinen SiC-Keimkristall. Bei einer ersten bekannten Vorrichtung zur Durchführung eines solchen Verfahrens ist in einer Vakuumanlage ein zylindrisches Reaktionsgefäß vorgesehen, dessen Außenwand eine hohlzylindrische Heizwand und eine obere und untere Heizplatte umschließt. Die Heizwand und die Heizplatten bestehen aus Elektrographit und sind mit einer außerhalb der Vakuumanlage angeordneten Hochfrequenz(HF)-heizspule induktiv gekoppelt. Innerhalt der Heizwand ist konzentrisch zur Heizwant eine hohlzylincrische Zylinderwand aus porösem Graphit angeordnet. Diese Zwischenwand trennt einen ebenfalls hohlzylindrischen Vorratsraum zwischen der Zwischenwand und der Heizwand von einem zylindrischen Reaktionsraum innerhalb der Zwischenwand. In dem unteren Teil des Reaktionsraumes ist symmetrisch zur Zylinderachse ein flacher SiC-Keimkristall angeordnet. Durch die Heizwand und die Heizplatten wird ein in den Vorratsraum gefüllter SiC-Vorrat auf eine Temperatur von etwa 2000°C bis etwa 2500°C erhitzt und das feste SiC wird sublimiert. Das dabei entstehende Gasgemisch aus den hauptsächlichen Komponenten Si, Si₂C und SiC₂, das im folgenden auch "SiC in der Gasphase" genannt wird, diffundiert durch die Poren des Graphits in den oberen Teil des Reaktionsraumes und von dort zu dem Keimkristall, der auf einer Kristallisationstemperatur von etwa 1900°C bis 2200°C gehalten wird. Auf dem Keimkristall kristallisiert das SiC aus. Der Temperaturgradient zwischen dem oberen Teil und dem unteren Teil des Reaktionsraumes wird auf höchstens 20°C/cm eingestellt, indem für die obere Heizplatte eine zusätzliche Wärmedämmung und/ oder eine zusätzliche Heizung und für den Keimkristall eine zusätzliche Kühlung vorgesehen werden. Außerdem wird ein Schutzgas, vorzugsweise Argon (Ar), in den Reaktionsraum eingeleitet zum Einstellen eines Druckes von etwa 1 bis 5 mbar, der dem Dampfdruck des SiC in der Gasphase entgegenwirkt. Mit einer solchen Vorrichtung können SiC-Einkristalle von wenigstens 30 mm Länge und mit einem Durchmesser von bis zu 40 mm hergestellt werden (DE-C-32 30 727).

Bei einer weiteren bekannten Vorrichtung sind anstelle einer gemeinsamen HF-Spule außerhalb des Vakuumgefäßes zwei Widerstandsheizungen innerhalb des Vakuumgefäßes angeordnet. Eine dieser beiden Widerstandsheizungen ist zum Erhitzen eines pulverförmigen SiC-Vorrats in einem Vorratsraum auf eine Sublimationstemperatur von typischerweise etwa 2300°C vorgesehen, und die andere Widerstandsheizung ist zum Erhitzen der Kristallisationsfläche an einem in einem Reaktionsraum angeordneten Keimkristall auf eine Kristallisationstemperatur von typischerweise 2200°C vorgesehen. Der Reaktionsraum ist dabei oberhalb des Vorratsraums angeordnet und von diesem durch eine Trennwand aus porösem Graphit getrennt. Durch die beiden, voneinander unabhängigen Widerstandsheizungen können bei dem Herstellungsprozeß die Temperatur des SiC-Pulvers und die Temperatur an der Kristallisationsfläche unabhängig voneinander geregelt werden. Der Temperaturgradient zwischen dem SiC-Pulver im Vorratsraum und der Kristallisationsfläche im Reaktionsraum bildet sich dann bei Vorgabe dieser beiden Temperaturen in Abhängigkeit von den thermischen Eigenschaften des Systems, insbesondere den thermischen Übergangskoeffizienten der Materialien und seiner Geometrie, von selbst aus. Durch diese unabhängige Einstellung der Sublimationstemperatur und der Kristallisationstemperatur kann der Wachstumsprozeß des auf den Keimkristall aufwachsenden Einkristalls positiv beeinflußt werden. Um während des Kristallwachstums einen annähernd konstanten Temperaturgradienten zwischen der Kristallisationsfläche am wachsenden Einkristall und dem während des Prozesses an Volumen abnehmenden SiC-Pulver einzustellen, sind der Keimkristall und der aufwachsende Einkristall auf einem Schaft axial zur SiC-Pulveroberfläche hin oder wegbewegbar angeordnet. Dieser Schaft ist außerdem rotierbar, so daß ein rotationssymmetrisches Aufwachsen erreicht wird und räumliche Fluktuationen im Gasfluß herausgemittelt werden. Mit einer solchen Vorrichtung wurden SiC-Kristalle der 6H-Modifikation mit 12 mm Durchmesser und 6 mm Höhe hergestellt (US 4 866 005).

Wegen Oberflächenreaktionen an der Oberfläche der Poren im Graphit der Zwischenwand lassen sich bei den bekannten Verfahren Verunreinigungen im aufgewachsenen SiC-Einkristall nicht vermeiden. Außerdem unterliegt die Porengröße des Graphits der Zwischenwand herstellungsbedingt relativ großen Schwankungen. Dadurch sind der Gastransport durch die Poren und damit auch die Wachstumsrate des einkristallinen SiC nicht exakt einzustellen. Schließlich kann pro Abscheideprozeß nur ein einziger Einkristall hergestellt werden, da der Keimkristall und damit der aufgewachsene Einkristall im Bereich der Symmetrieachse angeordnet werden müssen wegen der radialen Wärmezufuhr von außen und der axialen Wärmeabfuhr nach außen.

Der Erfindung liegt deshalb die Aufgabe zugrunde, die drei wesentlichen Teilprozesse Sublimation, Gastransport und Kristallisation bei einer solchen Vorrichtung und bei einem solchen Verfahren zum Herstellen von 510-Einkristallen besser steuerbar zu machen, so daß die Kristallqualität, die Einkristallausbeute und die Größe der Einkristalle gesteigert werden können. Außerdem sollen gleichzeitig mehrere Einkristalle gezüchtet werden können.

Diese Aufgabe wird gemäß der Erfindung gelöst mit den Merkmalen des Anspruchs 1 bzw. 12. Der Vorratsraum mit dem SiC-Vorrat und der Reaktionsraum mit dem Keimkristall werden räumlich voneinander getrennt angeordnet. Ein zusätzlicher Homogenisierungsraum ist zwischen dem Vorratsraum und dem Reaktionsraum angeordnet und mit diesen durch jeweils einen Gasteilkanal mit einem wohldefinierten Querschnitt verbunden. Dadurch können die Geometrie und insbesondere die Volumina des Vorratsraumes und des Reaktionsraumes unabhängig voneinander gewählt werden und beliebige Kristalldurchmesser erreicht werden im Gegensatz zu der zylindrisch-konzentrischen Anordnung beim zuvor beschriebenen Stand der Technik. Ferner kann bei vorgegebenem Druck und einer vorgegebenen Temperaturverteilung innerhalb des Systems durch die Abmessungen und Anordnung der Gasteilkanäle der Teilchenstrom der Gasmoleküle des SiC in der Gasphase bezüglich seiner Größe, seiner Richtung und seiner stöchiometrischen Zusammensetzung eingestellt werden.

Vorteilhafte Ausgestaltungen gemäß der Erfindung ergeben sich aus den jeweils abhängigen Unteransprüchen.

Zur näheren Erläuterung der Erfindung wird auf die Zeichnung Bezug genommen, in deren
- FIG. 1: eine Vorrichtung zum Herstellen von SiC-Einkristallen mit einem oberhalb des Reaktionsraumes angeordneten Vorratsraum,
- FIG. 2: eine Vorrichtung mit einem unterhalb des Reaktionsraumes angeordneten Vorratsraum,
- FIG. 3: eine Vorrichtung mit einem zwischen Vorratsraum und Reaktionsraum angeordneten und jeweils durch einen Gaskanal mit diesen verbundenen Homogenisierungsraum,
- FIG. 4: eine Vorrichtung mit mehreren, jeweils aus einem Vorratsraum, einem Reaktionsraum und einem Gaskanal aufgebauten Systemen mit einem gemeinsamen Heizsvstem und
- FIG. 5: eine Vorrichtung mit mehreren Reaktionsräumen, die jeweils über einen Gaskanal mit einem gemeinsamen Vorratsraum verbunden sind, und einem gemeinsamen Heizsystem
schematisch im Querschnitt dargestellt sind. Gleiche Teile sind dabei mit denselben Bezugszeichen versehen.

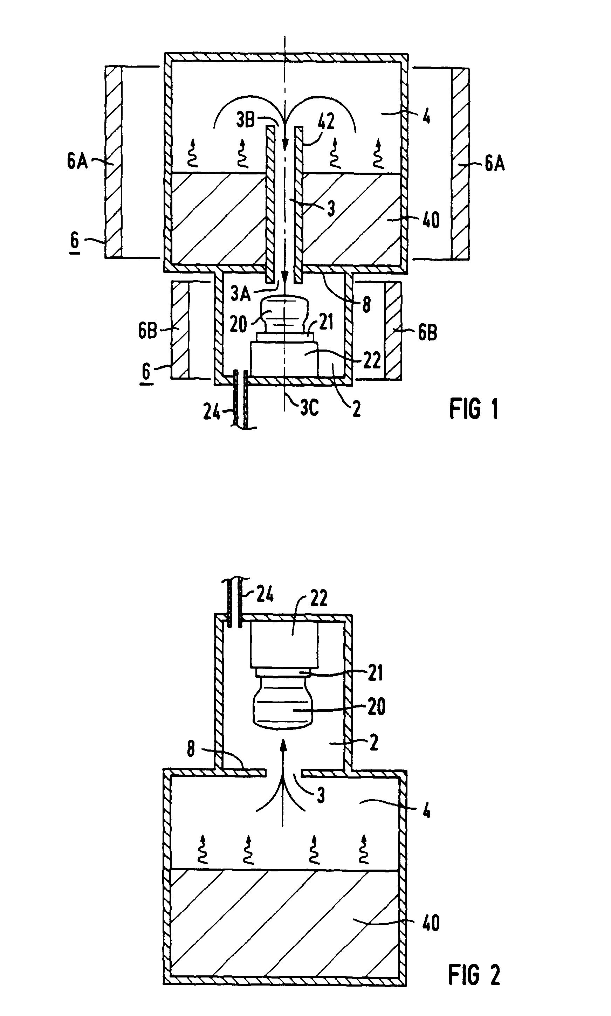

In FIG. 1 sind ein Reaktionsraum mit 2, ein Keimkristall mit 21, sein Keimhalter mit 22, ein Vorratsraum mit 4, ein Vorrat von festem SiC mit 40, eine Rückhaltevorrichtung für den Vorrat 40 mit 42, eine Trennwand mit 8, ein Gaskanal mit 3, dessen Eintrittsöffnung mit 3B und Austrittsöffnung mit 3A sowie Mittelachse mit 3C und eine Heizeinrichtung mit 6 bezeichnet. Der Vorratsraum 4 ist in seinem unteren Teil mit dem Vorrat 40 gefüllt. Der Vorrat 40 ist vorzugsweise aus technischem SiC in Pulverform oder massivem, im allgemeinen polykristallinem SiC gebildet und kann auch Dotierungsstoffe zum Dotieren des SiC-Einkristalls enthalten. Unterhalb des Vorratsraumes 4 ist der Reaktionsraum 2 angeordnet. Der Vorratsraum 4 und der Reaktionsraum 2 sind durch die undurchlässige Trennwand 8 voneinander getrennt und durch den Gaskanal 3 mit fest vorgegebenem Querschnitt miteinander verbunden, der durch die Trennwand 8 geführt ist. Durch diese Maßnahme können die Gastransportrate und auch die Richtung des Gasteilchenstromes eingestellt werden. Der Querschnitt des Gaskanals 3 wird im allgemeinen zwischen 0,05 mm² und 200 mm² und vorzugsweise zwischen 0,1 mm² und 100 mm² gewählt und kann sich auch entlang der Länge des Gaskanals 3 in vorgegebener Weise ändern.

Damit kein festes SiC aus dem Vorratsraum 4 in den Reaktionsraum 2 gelangen kann, ist die Rückhaltevorrichtung 42 für den Vorrat 40 vorgesehen. Vorzugsweise ist mit dieser Rückhaltevorrichtung 42 zugleich der Gaskanal 3 ausgebildet. Die Eintrittsöffnung 3B des Gaskanals 3 liegt dann höher als der Füllstand des Vorrats 40. Dazu kann ein Rohr vorgesehen sein, das höher ist als der Füllstand des Vorrats 40 und durch eine Öffnung in der Trennwand 8 gesteckt ist.

Der Vorrat 40 wird durch die ihm zugeordnete Heizeinrichtung 6A erhitzt und teilweise zersetzt. Ein Teil des SiC sublimiert, und die einzelnen Komponenten Si, Si₂C und SiC₂ des SiC in der Gasphase werden entlang der Richtung der eingezeichneten Pfeile durch den Gaskanal 3 in den Reaktionsraum 2 transportiert. In dem unteren Teil des Reaktionsraumes 2 ist der Keimkristall 21 auf dem Keimhalter 22 angeordnet. Auf diesen Keimkristall 21 wächst durch Auskristallisation des SiC aus der Gasphase ein Einkristall 20 auf.

Der SiC-Gasstrom kann durch eine entsprechende Anordnung des Gaskanals 3 in einer gewünschten Richtung gezielt auf die Kristallisationsfläche des Keimkristalls 21 bzw. des Einkristalls 20 gerichtet werden. In der dargestellten Ausführungsform ist die Mittelachse 3C des Gaskanals 3 wenigstens annähernd senkrecht zur Wachstumsbasis des flachen Keimkristalls 21 gerichtet, auf welcher der Einkristall 20 aufwächst. Man erreicht so eine Stabilisierung der konvexen Phasengrenze an der Oberfläche des aufwachsenden Einkristalls 20, da sich das SiC aus der Dampfphase vorwiegend in der Mitte abscheidet und nach außen verarmt.

Vorzugsweise sind zwei Heizeinrichtungen 6A und 6B für Vorratsraum 4 und Reaktionsraum 2 getrennt vorgesehen, die Teile einer Heizeinrichtung 6 oder vollkommen unabhängig voneinander sein können. Diese Maßnahme ermöglicht eine gut kontrollierbare Temperaturverteilung zwischen SiC-Vorrat 4 und SiC-Einkristall 20.

Der Keimkristall 21 und die Kristallisationsfläche am Einkristall 20 werden dann durch die dem Reaktionsraum 2 zugeordnete Heizeinrichtung 6B als Teil der Heizeinrichtung 6 auf einer Kristallisationstemperatur gehalten, die niedriger ist als die Sublimationstemperatur am Vorrat 40.

Die Heizeinrichtung 6 kann als induktiv an eine außerhalb des Systems angeordnete, nicht dargestellte Hochfrequenz (HF)-Heizspule gekoppeltes Wandsystem oder auch als Widerstandsheizung ausgebildet sein. Vorzugsweise sind die Heizleistungen der beiden Heizeinrichtungen 6A und 6B zum Erhitzen des Vorrats 2 bzw. der Kristallisationsfläche unabhängig voneinander steuerbar.

In einer besonders vorteilhaften Ausführungsform sind Mittel zum Zuführen eines Schutzgases vorgesehen, von denen nur eine vorzugsweise in den Reaktionsraum 2 führende Zuleitung 24 dargestellt ist. Dadurch kann zusätzlich der Druck im Reaktionsraum 2 und im Vorratsraum 4 eingestellt werden, der sich dann als Summe der Dampfpartialdrücke der Komponenten des SiC in der Gasphase und des Partialdruckes des Schutzgases ergibt. Damit kann man die Sublimationsrate des SiC beeinflussen. Typische Drücke liegen bei zwischen etwa 1 mbar und etwa 100 mbar und vorzugsweise zwischen 1 mbar und 20 mbar. Als Schutzgas wird im allgemeinen ein Edelgas und vorzugsweise Argon verwendet. Der Dampfdruck des SiC hängt außerdem exponentiell von der Temperatur ab, so daß auch durch eine Steuerung der Sublimationstemperatur die Sublimationsrate und damit die Kristallwachstumsrate eingestellt werden können. Zum Regeln dieser beiden wesentlichen Parameter Druck und Temperatur ist vorzugsweise ein nicht dargestellter Regler vorgesehen, der elektrisch mit den Mitteln zum Einleiten des Schutzgases und den Heizeinrichtungen verbunden ist. Diese beiden Parameter sind somit genau einstellbar, so daß auch die Wachstumsrate exakt zu kontrollieren ist. Die Mittel 4 zur Zufuhr eines Schutzgases in den Vorratsraum oder den Reaktionsraum 2 werden vorzugsweise auch zum Evakuieren des Systems vor dem Abscheideprozeß verwendet.

In einer Ausführungsform gemäß FIG. 2 ist der Vorratsraum 4 unterhalb des Reaktionsraums 2 angeordnet. Der Gaskanal 3 ist nun vorzugsweise als einfache Öffnung in der Trennwand 8 ausgebildet. Der Keimhalter 22 mit dem darauf befestigten Keimkristall 21 ist im oberen Teil des Reaktionsraumes 2 hängend angebracht, so daß der Keimkristall 21 und der darauf abgeschiedene Einkristall 20 der Öffnung des Gaskanals 3 zugewandt sind. Beim Gastransport des sublimierten SiC macht man sich in diesem Ausführungsbeispiel zusätzlich zum Temperaturgradienten die thermischen Auftriebskräfte zunutze.

Die Volumina des Vorratsraumes 4 und des Reaktionsraumes 2 können unterschiedlich groß sein und weitgehend unabhängig voneinander gewählt werden. Im allgemeinen wird das Volumen des Vorratsraumes 4 jedoch größer gewählt als das des Reaktionsraumes 2. Auch die räumliche Anordnung von Vorratsraum 4 und Reaktionsraum 2 zueinancer ist beliebig wätlbar und insbesondere nicht auf die vertikalen und axialsymmetrischen Ausführungsformen, gemäß den FIG. 1 oder 2 beschränkt.

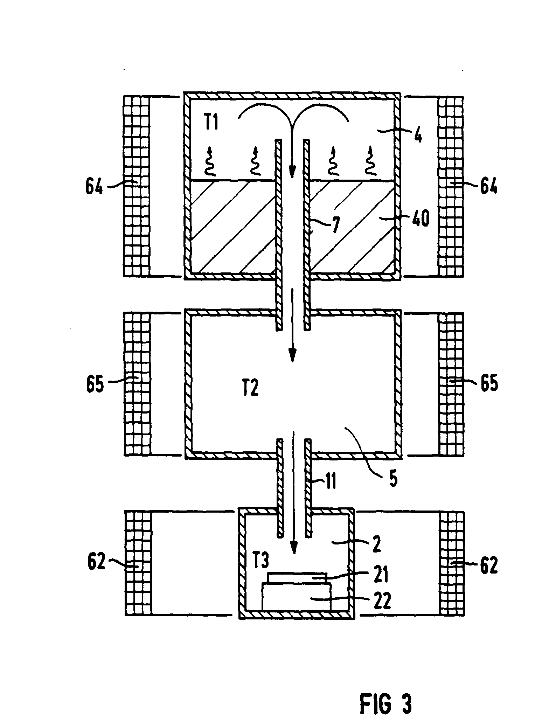

FiG. 3 zeigt eine Ausführungsform einer erfindungsgemäßen Vorrichtung mit einem bezüglich des Gasstromes zwischen dem Reaktionsraum 2 und dem Vorratsraum 4 angeordneten Homogenisierungsraum 5, der über einen Gasteilkanal 11 mit dem Reaktionsraum 2 und über einen weiteren Gasteilkanal 7 mit dem Vorratsraum 4 verbunden ist. Vorzugsweise sind die drei Räume axial übereinander angeordnet. Dadurch können zylinderförmige Heizeinrichtungen verwendet werden. Der Gasstrom aus den drei Komponenten Si, Si₂C und SiC₂ passiert also auf seinem Weg von dem Vorratsraum 4 zum Reaktionsraum 2 den Homogenisierungsraum 5, der auf eine im allgemeinen zwischen der Sublimationstemperatur T₁ und der Kristallisationstemperatur T₃ liegende Temperatur T₂ ge-heizt ist. Die Dampfdrücke der einzelnen Komponenten des SiC in der Gasphase hängen unterschiedlich stark von dieser Temperatur T₂ ab. Damit kann in dem Homogenisierungsraum 5 durch Steuern seiner Temperatur T₂ das stöchiometrische Verhältnis Si:Si₂C:SiC₂ der drei Komponenten verändert werden. Zum unabhängigen Einstellen der Temperaturen T₁, T₂ und T₃ sind dem Reaktionsraum 2 eine Heizeinrichtung 62, dem Homogenisierungsraum 5 eine Heizeinrichtung 65 und dem Vorratsraum 4 eine Heizeinrichtung 64 zugeordnet, die jeweils als Widerstandsheizung dargestellt sind.

Selbstverständlich ist es auch möglich, bei den in den übrigen Figuren dargestellten Ausführungsformen einen Homogenisierungsraum gemäß Figur 3 vorzusehen.

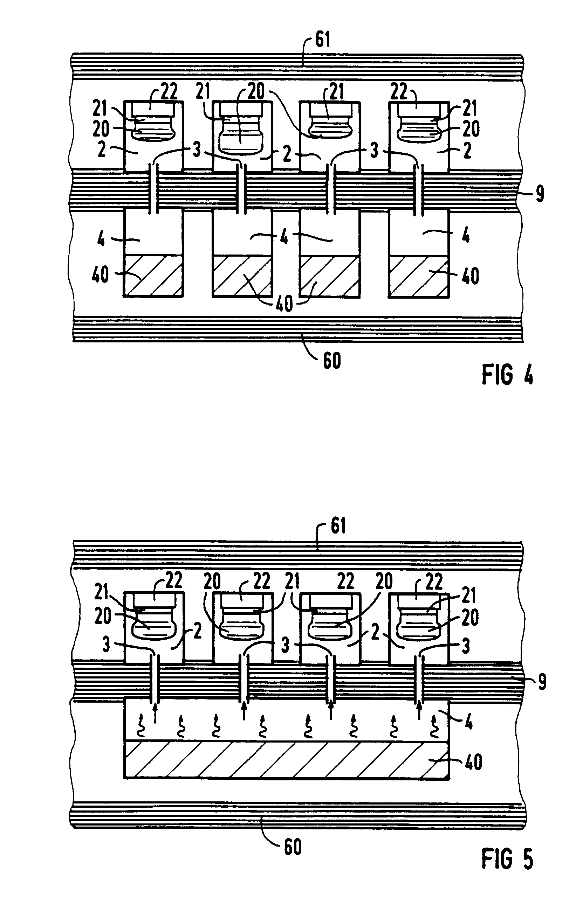

Bei dem Verfahren und der Vorrichtung gemäß der Erfindung ist auch die Möglichkeit zum gleichzeitigen Herstellen mehrerer SiC-Einkristalle gegeben. In einer Ausführungsform gemäß FIG. 4 sind dazu mehrere, jeweils aus einem Reaktionsraum 2, einem Gaskanal 3 und einem Vorratsraum 4 aufgebaute Systeme nebeneinander vorgesehen. Dargestellt sind Systeme in einer Ausfünrungsform gemäß FIG. 2 mit oben angeordneten Reaktionsräumen 2 und unten angeordneten Vorratsräumen 4. Es können allerdings auch Systeme in einer Ausführungsform gemäß FIG. 1 vorgesehen sein. Den Reaktionsräumen 2 ist eine gemeinsame Heizeinrichtung 61 und den Vorratsräumen 4 eine gemeinsame Heizeinrichtung 60 zugeordnet. Zur kontrollierten und unabhängigen Steuerung der Temperaturen in den Reaktionsräumen 2 und den Vorratsräumen 4 ist vorzugsweise dazwischen eine thermische Isolationswand 9 angeordnet, durch die die Gaskanäle 3 durchgeführt sind. Die aufwachsenden Einkristalle 20 sind verschieden groß dargestellt. Damit soll angedeutet werden, daß die Wachstumsraten in den einzelnen Systemen insbesondere durch verschiedene Querschnitte ihrer Gaskanäle 3 voneinander abweichen können.

In einer anderen Ausführungsform gemäß FIG. 5 ist mehreren Reaktionsräumen 2 ein gemeinsamer Vorratsraum 4 mit einem Vorrat 40 zugeordnet, der jeweils durch einen Gaskanal 3 mit jedem Reaktionsraum 2 verbunden ist. Vorzugsweise ist wieder eine Isolationswand 9 vorgesehen. Dem gemeinsamen Vorratsraum 4 ist eine Heizeinrichtung 60 und den Reaktionsräumen 2 wieder eine gemeinsame Heizeinrichtung 61 zugeordnet. Es sind auch mehrere getrennte Heizeinrichtungen für die Reaktionsräume 2 möglich.

Auch in Ausführungsformen mit mehreren Systemen können Homogenisierungsräume, die entweder einzelnen oder mehreren Reaktionsräumen 2 bzw. Vorratsräumen 4 zugeordnet sind, und/oder Mittel zum Zuführen eines Schutzgases vorgesehen sein.

Bevorzugte Modifikationen des aufgewachsenen SiC-Einkristalles 20 sind 4H, 6H und 15R. Vorzugsweise besteht auch der Keimkristall 21 aus SiC dieser Modifikationen.

Als Materialien für die Komponenten der Vorrichtung kommen alle entsprechend hitzebeständigen Stoffe in Frage, insbesondere hochreiner Elektrographit. Außerdem können die Wände mit vorzugsweise pyrolytisch erzeugten, hitzebeständigen Beschichtungen versehen sein.

## Patentansprüche

1. Vorrichtung zum Herstellen von Einkristallen (20) aus Siliciumcarbid (SiC) mit
a) einem Reaktionsraum (2), in dem ein Keimhalter (22) für einen Keimkristall (21) zum Aufwachsen eines Einkristalls (20) aus SiC aus der Gasphase angeordnet ist,
b) einem Vorratsraum (4), der wenigstens teilweise mit einem Vorrat (40) aus festem SiC gefüllt ist,
c) einem Homogenisierungsraum (5), der über einen ersten Gaskanal (7) mit dem Vorratsraum (4) und über einen zweiten Gaskanal (11) mit dem Reaktionsraum (2) verbunden ist,
und
d) wenigstens einer Heizeinrichtung (6) zum Erzeugen von SiC in der Gasphase aus dem SiC-Vorrat (40) in dem Vorratsraum (4), zum Steuern der Temperatur im Homogenisierungsraum (5) sowie zum Einstellen einer Temperaturverteilung in dem Reaktionsraum (2).

2. Vorrichtung nach Anspruch 1, bei der eine Austrittsöffnung des zweiten Gaskanals (11) dem Keimhalter (22) direkt gegenüber so angeordnet ist, daß eine Mittelachse des zweiten Gaskanals (11) wenigstens annähernd senkrecht zur Kristallisationsfläche eines auf dem Keimhalter (22) angeordneten Keimkristalls (21) gerichtet ist.

3. Vorrichtung nach Anspruch 1 oder Anspruch 2, bei der der Vorratsraum (4) oberhalb des Reaktionsraumes (2) angeordnet ist.

4. Vorrichtung nach Anspruch 1 oder Anspruch 2, bei der der Vorratsraum (4) unterhalb des Reaktionsraumes (2) angeordnet ist.

5. Vorrichtung nach einem der vorhergehenden Ansprüche, bei der dem Homogenisierungsraum (5) eine eigene Heizeinrichtung (65) zugeordnet ist.

6. Vorrichtung nach einem der vorhergehenden Ansprüche, bei der der Vorratsraum (4), der Homogenisierungsraum (5) und der Reaktionsraum (2) sowie die beiden dazwischen angeordneten Gaskanäle (7 und 11) axial zueinander angeordnet sind.

7. Vorrichtung nach einem der vorhergehenden Ansprüche, bei der Mittel zum Zuführen eines Schutzgases vorgesehen sinc.

8. Vorrichtung nach einem der vorhergehenden Ansprüche, bei der mehrere Keimhalter (22) vorgesehen sind, denen jeweils ein zweiter Gaskanal zugeordnet ist.

9. Vorrichtung nach Anspruch 8, bei der die Keimhalter (22) in einem gemeinsamen Reaktionsraum (2) angeordnet sind.

10. Vorrichtung nach Anspruch 8 oder Anspruch 9, bei der die ersten Gaskanäle an einen gemeinsamen Vorratsraum angeschlossen sind.

11. Vorrichtung nach einem der vorhergehenden Ansprüche, bei der der mindestens eine Reaktionsraum (2) von dem zumindest einen Vorratsraum (4) durch eine thermische Isolationswand (9) getrennt ist und dem mindestens einen Reaktionsraum (2) eine erste Heizeinrichtung (60) und dem mindestens einen Vorratsraum (4) eine zweite, von der ersten unabhängige Heizeinrichtung (61) zugeordnet sind.

12. Verfahren zum Herstellen von Einkristallen (20) aus Siliciumcarbid (SiC), bei dem
a) ein Vorrat (40) aus festem SiC in einem Vorratsraum (4) vorgesehen wird,
b) ein Keimkristall (21) in einem Reaktionsraum (2) vorgesehen wird,
c) mittels wenigstens einer Heizeinrichtung (6) aus dem Vorrat (40) SiC in der Gasphase erzeugt wird und eine Temperaturverteilung in dem Reaktionsraum (2) eingestellt wird,
d) SiC in der Gasphase vom Vorratsraum (4) durch einen ersten Gaskanal (7), einen Homogenisierungsraum (5) und einen zweiten Gaskanal (11) zum Keimkristall (21) transportiert wird und dort als SiC-Einkristall (20) aufwächst,
e) die Temperatur (T₂) im Homogenisierungsraum (5) gesteuert wird zum Einstellen der Zusammensetzung des SiC in der Gasphase.

13. Verfahren nach Anspruch 12, bei dem der Teilchenstrom des SiC in der Gasphase wenigstens annähernd senkrecht auf die Kristallisationsfläche am Keimkristall (21) bzw. aufwachsenden Einkristall (20) gerichtet wird.

14. Verfahren nach Anspruch 12 oder Anspruch 13, bei dem die Kristallisationstemperatur an der Kristallisationsfläche am Keimkristall (21) bzw. am aufwachsenden Einkristall (20) und die Sublimationstemperatur am Vorrat (40) unabhängig voneinander eingestellt werden.

15. Verfahren nach einem der Ansprüche 12 bis 14, bei dem der Druck in dem Vorratsraum (4) und dem Reaktionsraum (2) durch Zuführen eines Schutzgases eingestellt wird.

## Claims

1. Device for producing single crystals (20) of silicon carbide (SiC), having
a) a reaction chamber (2) in which a seed holder (22) for a seed crystal (21) is arranged for growing a single crystal (20) of SiC from the gas phase,
b) a supply chamber (4) which is filled at least partially with a supply (40) of solid SiC,
c) a homogenization chamber (5) which is connected by way of a first gas channel (7) to the supply chamber (4) and by way of a second gas channel (11) to the reaction chamber (2),
and
d) at least one heating device (6) for generating SiC in the gas phase from the SiC supply (40) in the supply chamber (4), for controlling the temperature in the homogenization chamber (5) and for adjusting a temperature distribution in the reaction chamber (2).

2. Device according to claim 1, wherein an exit opening of the second gas channel (11) is arranged directly opposite the seed holder (22) in such a way that a centre axis of the second gas channel (11) is directed at least approximately perpendicular to the crystallization surface of a seed crystal (21) arranged on the seed holder (22).

3. Device according to claim 1 or claim 2, wherein the supply chamber (4) is arranged above the reaction chamber (2).

4. Device according to claim 1 or claim 2, wherein the supply chamber (4) is arranged below the reaction chamber (2).

5. Device according to one of the preceding claims, wherein the homogenization chamber (5) is allocated its to own heating device (65).

6. Device according to one of the preceding claims, wherein the supply chamber (4), the homogenization chamber (5) and the reaction chamber (2) as well as the two gas channels (7 and 11) arranged between them are arranged axially with respect to each other.

7. Device according to one of the preceding claims, wherein means for supplying a protective gas are provided.

8. Device according to one of the preceding claims, wherein several seed holders (22) are provided, to which a respective second gas channel is allocated.

9. Device according to claim 8, wherein the seed holders (22) are arranged in a common reaction chamber (2).

10. Device according to claim 8 or claim 9, wherein the first gas channels are connected to a common supply chamber.

11. Device according to one of the preceding claims, wherein the at least one reaction chamber (2) is separated from the at least one supply chamber (4) by a thermal insulation wall (9) and there is allocated to the at least one reaction chamber (2) a first heating device (60) and to the at least one supply chamber (4) a second heating device (61) which is independent of the first one.

12. Method for producing single crystals (20) of silicon carbide (SiC), wherein
a) a supply (40) of solid SiC is provided in a supply chamber (4),
b) a seed crystal (21) is provided in a reaction chamber (2),
c) by means of at least one heating device (6) SiC is generated from the supply (40) in the gas phase and a temperature distribution is set in the reaction chamber (2),
d) SiC in the gas phase is transported from the supply chamber (4) through a first gas channel (7), a homogenization chamber (5) and a second gas channel (11) to the seed crystal (21) and grows there as a SiC single crystal (20),
e) the temperature (T₂) in the homogenization chamber (5) is controlled in order to adjust the composition of the SiC in the gas phase.

13. Method according to claim 12, wherein the particle flow of the SiC in the gas phase is directed at least approximately perpendicular to the crystallization surface on the seed crystal (21) or growing single crystal (20).

14. Method according to claim 12 or claim 13, wherein the crystallization temperature on the crystallization surface on the seed crystal (21) or on the growing single crystal (20) and the sublimation temperature on the supply (40) are adjusted independently of each other.

15. Method according to one of claims 12 to 14, wherein the pressure in the supply chamber (4) and the reaction chamber (2) is adjusted by supplying a protective gas.

## Revendications

1. Dispositif de fabrication de monocristaux (20) en carbure de silicium (SiC), comportant
a) une chambre de réaction (2), dans laquelle est disposé un support de germe (22) pour un germe cristallin (21), pour assurer la croissance d'un monocristal (20) en SiC en phase gazeuse,
b) une chambre de réserve (4), qui au moins partiellement est remplie d'une réserve (40) constituée de SiC solide,
c) une chambre d'homogénéisation (5), qui par l'intermédiaire d'un premier canal de gaz (7) communique avec la chambre de réserve (4) et qui par l'intermédiaire d'un deuxième canal de gaz (11) communique avec la chambre de réaction (2), et
d) au moins un dispositif de chauffage (6), pour produire du SiC en phase gazeuse à partir de la réserve de SiC (40) dans la chambre de réserve (4), pour se rendre maître de la température dans la chambre d'homogénéisation (5) et pour régler une répartition des températures dans la chambre de réaction (2).

2. Dispositif selon la revendication 1, dans lequel un orifice de sortie du deuxième canal de gaz (11) est disposé, en étant directement opposé au support de germe (22), de façon qu'un axe central du deuxième canal de gaz (11) soit dirigé d'une manière au moins approximative perpendiculairement à la surface de cristallisation du germe cristallin (21) disposé sur le support de germe (22).

3. Dispositif selon la revendication 1 ou 2, dans lequel la chambre de réserve (4) est disposée au-dessus de la chambre de réaction (2).

4. Dispositif selon la revendication 1 ou 2, dans lequel la chambre de réserve (4) est disposée en-dessous de la chambre de réaction (2).

5. Dispositif selon l'une des revendications précédentes, dans lequel un dispositif de chauffage unique (65) est affecté à la chambre d'homogénéisation (5).

6. Dispositif selon l'une des revendications précédentes. dans lequel la chambre de réserve (4), la chambre d'homogénéisation (5) et la chambre ce réaction (2), ainsi que les deux canaux de gaz (7 et 11) disposés entre elles. sont disposés axialement les uns par rapport aux autres.

7. Dispositif selon l'une des revendications précédentes. Dans lequel des moyens sont prévus pour amener un gaz protecteur.

8. Dispositif selon l'une des revendications précédentes, dans lequel plusieurs supports de germe (22) sont présents, à chacun desquels est affecté un deuxième canal de gaz.

9. Dispositif selon la revendication 8, dans lequel les supports de germe (22) sont disposés dans une chambre de réaction commune (2),

10. Dispositif selon la revendication 8 ou 9, dans lequel les premiers canaux de gaz sont raccordés à une chambre de réserve commune.

11. Dispositif selon l'une des revendications précédentes, dans lequel au moins une chambre de réaction (2) est séparée d'au moins une chambre de réserve (4) par une paroi (9) à effet d'isolation thermique, et qu'à au moins une chambre de réaction (2) est affecté un premier dispositif de chauffage (60), et qu'à au moins une chambre de réserve (4) est affecté un deuxième dispositif de chauffage (61), indépendamment du premier.

12. Procédé de fabrication de monocristaux (20) de carbure de silicium (SiC), dans lequel
a) on prévoit dans une chambre de réserve (4) une réserve (40) de SiC solide,
b) on prévoit un germe cristallin (21) dans une chambre de réaction (2),
c) à l'aide d'au moins un dispositif de chauffage (6), on produit à partir de la réserve (40) du SiC en phase gazeuse, la répartition des températures étant réglée dans la chambre de réaction (2),
d) le SiC en phase gazeuse est transporté de la chambre de réserve (4) au germe cristallin (21), en passant par un premier canal de gaz (7), une chambre d'homogénéisation (5) et un deuxième canal de gaz (11), pour y subir une croissance sous forme d'un monocristal de SiC (20),
e) la température (T₂) dans la chambre d'homogénéisation (5) est régulée pour régler la composition du SiC en phase gazeuse.

13. Procédé selon la revendication 12, dans lequel le courant de particules du SiC en phase gazeuse est dirigé d'une manière au moins approximative perpendiculairement à la surface de cristallisation du germe cristallin (21) ou du monocristal (20) en cours de croissance.

14. Procédé selon la revendication 12 ou 13, dans lequel la température de cristallisation sur la surface de cristallisation du germe cristallin (21) ou sur le monocristal (20) en cours de croissance, et la température de sublimation au niveau de la réserve (40), sont réglées indépendamment l'une de l'autre.

15. Procédé selon l'une des revendications 12 à 14, dans lequel on ajuste la pression dans la chambre de réserve (4) et dans la chambre de réaction (2) en amenant un gaz protecteur.
